# DEMANDE DE BREVET EUROPEEN

(11) **EP 1 713 051 A1**
(43) Date de publication de la demande: **18.10.2006**
(21) Numéro de dépôt: 06290444.6
(22) Date de dépôt: 20.03.2006
(51) Int. Cl.: G09G 3/28, H03K 17/687

(54) **Dispositif de décalage de niveau de tension**

(30) Priorité: 04.04.2005 FR 0503321
(71) Demandeur: STMicroelectronics SA, 92120 Montrouge (FR)
(72) Inventeur: Bourgoin, Jerome, 38600 Fontaine (FR); Troussel, Gilles, 38000 Grenoble (FR)
(74) Mandataire: Bentz, Jean-Paul

(57) **Abrégé**

L'invention a pour objet un dispositif comprenant
-une entrée de commande (Vcom) ;
-des premier et seconds noeuds (NS1, NS2) ;
-des premier et deuxième transistors haute tension à oxyde de grille épais (P1, P2), la première électrode du premier transistor étant connectée au premier noeud, la seconde électrode de chacun de ces transistors étant connectée au second noeud, la grille de chacun de ces transistors étant connectée à la première électrode de l'autre de ces transistors ;
-des troisième et quatrième transistors haute tension (N1, N2), ayant une première électrode connectée à la masse, ayant chacun une seconde électrode dont l'une est connectée à la première électrode du premier transistor et dont l'autre est connectée à la première électrode du second transistor, leurs grilles étant connectées par un inverseur et l'une d'elles étant connectée à l'entrée de commande.

## Description

L'invention concerne les dispositifs d'alimentation et en particulier les dispositifs de décalage de niveau de tension.

Des circuits intégrés, tels que des pilotes d'affichage, font appel à des tensions de pilotage atteignant 100 Volts en étant commandés par des circuits logiques CMOS standards à 5 Volts. Ainsi, des dispositifs de décalage de niveau de tension complexes sont nécessaires pour convertir un signal à 5 V en un signal de sortie au niveau souhaité. De tels dispositifs étant fréquemment intégrés dans des appareils alimentés par batterie, ils doivent présenter une consommation électrique aussi réduite que possible.

Des écrans à cristaux liquides cholestériques ont été développés et sont notamment utilisés dans des appareils ayant une fréquence de modification d'image très basse. De tels écrans sont utilisés pour leur capacité de mémorisation de l'image en l'absence d'alimentation mais nécessitent l'application de tensions de l'ordre de 50 à 100 Volts sur leurs lignes de pixels pour que l'image soit modifiée. De tels écrans nécessitent ainsi des pilotes d'affichage fournissant de telles tensions avec une consommation électrique extrêmement basse.

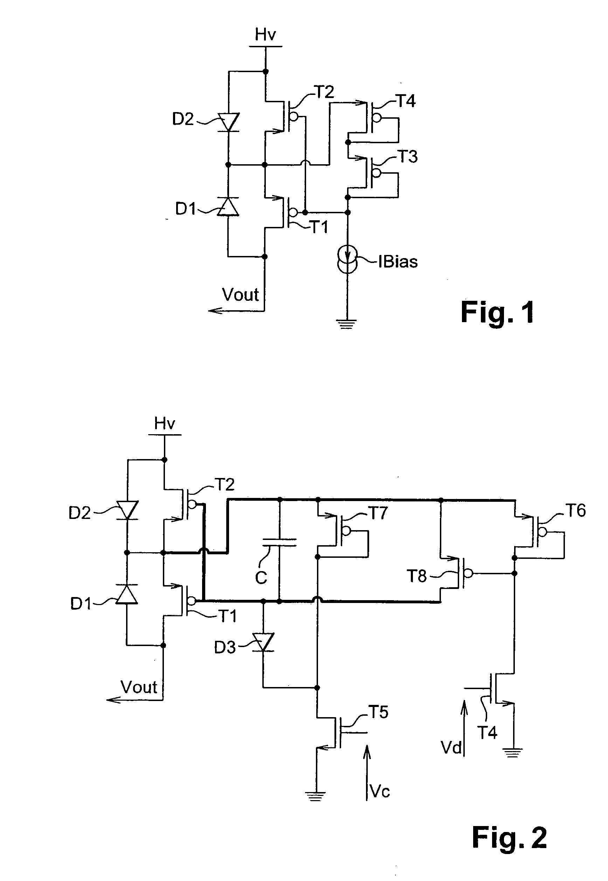

Un pilote d'affichage connu présente trois sources de tension présentant différents niveaux devant être appliqués sélectivement sur un pixel par un noeud de sortie vout. Une première source fournit une tension supérieure, une seconde source fournit une tension intermédiaire et une troisième source fournit une tension inférieure. La seconde source' de tension comprend un dispositif de décalage de tension dit statique. Un tel dispositif de décalage de tension transforme un signal basse tension pour commander un commutateur analogique muni de transistors haute tension PMos T1 et T2 montés tête-bêche comme illustré à la figure 1. Ce commutateur analogique est destiné à fournir la tension intermédiaire. Ce montage tête-bêche permet de passer de la tension supérieure à la tension intermédiaire sans retour à la tension inférieure. Les transistors T1 et T2 induisent en outre deux diodes parasites D1 et D2 tête-bêches. Le drain du transistor T2 est connecté à une alimentation haute tension Hv et le drain du transistor T1 est connecté au noeud de sortie Vout. Les sources des transistors T1 et T2 sont connectées l'une à l'autre. La tension de sortie sur le noeud Vout est déterminée par la différence de tension entre la source de T4 et le drain de T3. Cette différence de tension est générée par le courant fourni par une source de courant Ibias et traversant les transistors T3 et T4 connectés en diode.

Un tel dispositif de décalage de niveau de tension présente l'inconvénient de consommer du courant en continu par la source de courant Ibias. Une telle consommation de courant en continu est rédhibitoire pour une alimentation par batterie.

La figure 2 illustre un dispositif de décalage de niveau de tension dit dynamique commandant un commutateur analogique muni de transistors haute tension PMos T1 et T2. Ce dispositif est également détaillé dans la publication « A New Architecture for Monolithic Low-Power High-Voltage Display Driver » de Messieurs Doutreloigne, De Smet et Van Calster de l'université de Gant (N° ISSN : ISSN1083-1312/00/2001-0115-$1.00 +.00). Ce dispositif utilise une commande dynamique de la charge des grilles des transistors T1 et T2 afin de supprimer la consommation statique du dispositif de décalage de niveau de tension de la figure 1.

Les sources des transistors T1 et T2 sont connectées l'une à l'autre. Les grilles des transistors T1 et T2 sont connectées l'une à l'autre. Le drain du transistor T2 est connecté à une alimentation haute tension Hv et le drain du transistor T1 est connecté à un noeud de sortie Vout. Les transistors T1 et T2 induisent en outre deux diodes D1 et D2 parasites.

Le dispositif de décalage de niveau de tension comprend un condensateur C connecté entre la source et la grille des transistors T1 et T2. Le dispositif de décalage de niveau de tension comprend également des transistors CMOS standards T4 à T8 de charge et de décharge du condensateur C.

Les transistors T5 et T7 sont utilisés pour la charge du condensateur C et sont connectés en série entre la source du transistor T1 et la masse. Le transistor T5 est un transistor de puissance NMos recevant un signal de commande de charge sur sa grille. L'anode et la cathode d'une diode D3 sont connectées respectivement à la grille de T1 et au drain de T5. Le transistor T7 est un transistor PMos présentant une connexion entre sa grille et son drain.

Des transistors T4, T6 et T8 sont utilisés pour la décharge du condensateur C. Les transistors T4 et T6 sont connectés en série entre la source du transistor T1 et la masse. Le transistor T4 est un transistor de puissance NMos recevant un signal de commande de décharge sur sa grille. Le transistor T6 est un transistor PMos présentant une connexion entre sa grille et son drain. La source du transistor T8 est connectée à la source de T1, son drain est connecté à la grille de T1 et sa grille est connectée à la grille de T6.

Les signaux de charge et de décharge appliqués respectivement sur T5 et T4 ont un rapport cyclique très réduit, afin de réduire autant que possible la consommation du dispositif de décalage de niveau de tension.

Un tel dispositif de décalage de niveau de tension présente cependant des inconvénients. Des signaux de charge et de décharge cycliques sont nécessaires. De plus, la surface de substrat occupée par un tel dispositif est élevée.

En outre, les transistors T1 et T2 sont sensibles au niveau de tension sur le noeud de sortie Vout. Ainsi, si un autre circuit applique une tension Vout supérieure au niveau Hv, un courant traverse la diode D1 et le condensateur C et charge des capacités parasites entre la masse et la grille de T1. La charge du condensateur C, dont la capacité est limitée pour faciliter son intégration, rend alors les transistors T1 et T2 passants. Dès lors le commutateur analogique génère une consommation parasite et la tension sur le noeud Vout baisse par rapport à son niveau nominal.

L'invention vise à résoudre un ou plusieurs de ces inconvénients. L'invention porte ainsi sur un dispositif de décalage de niveau de tension, comprenant :
- une entrée de commande ;
- des premier et seconds noeuds de sortie ;
- des premier et deuxième transistors haute tension à oxyde de grille épais d'un premier type, présentant chacun une première et une deuxième électrode de conduction et une grille, la première électrode de conduction du premier transistor étant connectée au premier noeud de sortie, la seconde électrode de conduction de chacun de ces transistors étant connectée au second noeud de sortie, la grille de chacun de ces transistors étant connectée à la première électrode de conduction de l'autre de ces transistors ;
- des troisième et quatrième transistors CMOS haute tension d'un second type, présentant chacun une première électrode de conduction connectée à la masse, présentant chacun une seconde électrode de conduction dont l'une est connectée à la première électrode de conduction du premier transistor et dont l'autre est connectée à la première électrode de conduction du second transistor, leurs grilles étant connectées ensembles par l'intermédiaire d'un inverseur et l'une de ces grilles étant connectée à l'entrée de commande.

Selon une variante, les premier et second transistors sont de type PMos et leur première électrode de conduction est leur drain, les troisième et quatrième transistors sont de type NMos et leur première électrode de conduction est leur source.

Selon encore une variante, la tension drain-source maximale de chacun desdits transistors est supérieure à 20 Volts.

Selon une autre variante, la tension maximale grille-source des premier et deuxième transistors est supérieure à 20 Volts.

L'invention concerne également un commutateur analogique à haute tension destiné à être commandée par un dispositif de décalage de niveau de tension, comprenant :
- des premier et second noeuds d'entrée ;
- un noeud de sortie et une entrée d'alimentation haute tension ;
- des premier et second transistors haute tension à oxyde de grille épais d'un premier type, présentant chacun une première et une deuxième électrode de conduction et une grille, leurs grilles étant connectées au premier noeud d'entrée, leurs deuxièmes électrodes de conduction étant connectées au second noeud d'entrée, leurs premières électrodes de conduction étant connectées respectivement à l'entrée d'alimentation haute tension et au noeud de sortie.

L'invention concerne encore un système comprenant :
- un dispositif de décalage de niveau de tension décrit ci-dessus;
- un commutateur analogique à haute tension décrit ci-dessus, dont les premier et second noeuds d'entrée sont connectés respectivement aux premier et second noeuds de sortie du dispositif.

Selon une variante, le système comprend une alimentation supérieure à 20 Volts connectée à l'entrée d'alimentation.

L'invention porte en outre sur un multiplexeur de tensions, comprenant :
- un système tel que décrit ci-dessus ;
- au moins une source de tension :

- présentant une entrée d'alimentation à un niveau de tension supérieur à celui appliqué sur l'entrée d'alimentation haute tension du commutateur analogique du système, une entrée de commande et un noeud de sortie connecté au noeud de sortie du système ;
- apte à appliquer le niveau de tension de son entrée d'alimentation sur son noeud de sortie lors de l'application d'un signal de commande approprié sur son entrée de commande ;
- une sortie connectée au noeud de sortie du système et au noeud de sortie de la source de tension ;
- un dispositif de commande apte à appliquer sélectivement des signaux de commande sur les entrées de commande respectives du dispositif de décalage de niveau de tension du système et de la source de tension de sorte que le commutateur du système ou la source de tension applique le niveau de tension de son entrée d'alimentation sur son noeud de sortie.

L'invention traite par ailleurs d'un écran d'affichage, comprenant :
- une matrice de pixels, chaque pixel présentant deux électrodes et étant commandé par une différence de tension entre ses électrodes;
- un pilote d'affichage comprenant un multiplexeur de tensions tel que décrit ci-dessus, commandant au dispositif de commande l'application d'un niveau de tension donné sur la sortie du multiplexeur, connectant une électrode d'un pixel à la sortie du multiplexeur.

Selon une variante, la matrice est une matrice de pixels à cristaux liquides cholestériques.

D'autres caractéristiques et avantages de l'invention ressortiront clairement de la description qui en est faite ci-après, à titre indicatif et nullement limitatif, en référence aux dessins annexés, dans lesquels :
- la figure 1 représente un dispositif de décalage de niveau de tension et un commutateur analogique associé selon un premier état de la technique ;
- la figure 2 représente un dispositif de décalage de niveau de tension et un commutateur analogique associé selon un second état de la technique ;
- la figure 3 représente un exemple de dispositif de décalage de niveau de tension et un commutateur analogique selon l'invention ;
- la figure 4 représente schématiquement un multiplexeur de tension intégrant un dispositif de décalage de niveau de tension et un commutateur analogique selon l'invention.

L'invention propose d'appliquer des signaux haute tension sur les grilles de transistors de sortie à oxyde de grille épais d'un commutateur analogique haute tension. L'invention propose également un dispositif de décalage de niveau de tension adapté pour appliquer un tel niveau de tension et à résister à un tel niveau de tension sur sa grille.

Un transistor à oxyde de grille épais ou TGO (pour Thick Gate-oxide) désigne généralement un transistor dont l'oxyde de grille présente une épaisseur supérieure à 200 nm. L'épaisseur de l'oxyde de grille d'un tel transistor est typiquement de l'ordre de 300, 500 ou 750 nm. La tension grille-source maximale d'un tel transistor est typiquement supérieure à 90 Volts.

L'invention permet de n'utiliser qu'un unique signal de commande. Ce signal de commande peut également être continu lorsque le commutateur analogique est fermé. L'invention permet également de réduire la consommation et l'espace occupé par le dispositif de décalage de niveau de tension ou un multiplexeur l'intégrant.

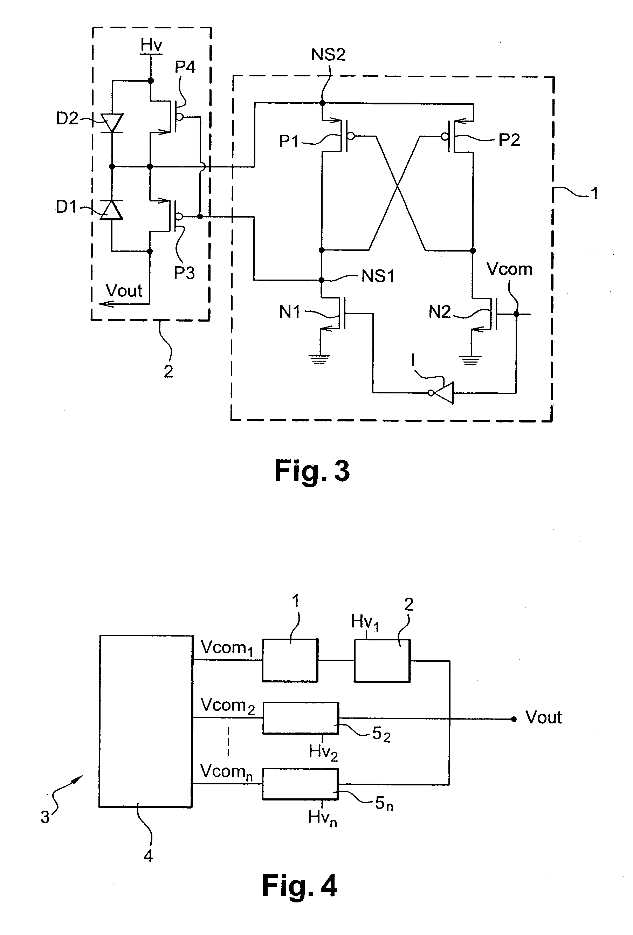

La figure 3 représente un dispositif de décalage de niveau de tension 1 commandant un commutateur analogique 2.

Le dispositif de décalage de niveau de tension 1 comprend des premier et second noeuds de sortie NS1 et NS2. Le dispositif 1 comprend en outre des premier et deuxième transistors PMos haute tension P1 et P2 à oxyde de grille épais. P1 a son drain connecté au premier noeud de sortie et a sa source connectée au second noeud de sortie NS2. P2 a sa source connectée au second noeud de sortie NS2. Les grilles de P1 et P2 sont connectées respectivement aux drains de P2 et P1.

Le dispositif 1 comprend en outre des troisième et quatrième transistors NDMos haute tension N1 et N2. Les drains de N1 et N2 sont connectés respectivement aux drains de P1 et P2. Les sources de N1 et N2 sont connectées à la masse.

Le dispositif 1 comprend une entrée de commande Vcom. Le niveau logique de l'entrée de commande Vcom est appliqué sur la grille du transistor N2. La grille du transistor N1 est connectée à l'entrée de commande Vcom par l'intermédiaire d'un inverseur I.

Le commutateur analogique à haute tension 2 est connecté aux noeuds de sortie NS1 et NS2. Le commutateur 2 comprend deux transistors PMos haute tension P3 et P4 à oxyde de grille épais montés têtes-bêches. Leurs diodes parasites D1 et D2 ont également été représentées.

Les grilles de P3 et P4 sont connectées au noeud de sortie NS1. Les sources de P3 et P4 sont connectées au noeud de sortie NS2. Le drain de P3 est connecté à un noeud de sortie Vout et le drain de P4 est connecté à une entrée d'alimentation haute tension Hv.

Les transistors P1 et P2 sont destinés à commander la commutation des transistors P3 et P4 en chargeant les capacités parasites présentes sur le noeud NS1. Ces capacités sont principalement induites par les caissons de P1 et N1. Lorsqu'un niveau logique bas est appliqué sur l'entrée de commande Vcom, le commutateur analogique 2 est rendu passant. Les transistors N2 et P1 sont bloqués. Le transistor N1 est rendu passant et rend passants les transistors P2, P3 et P4 en tirant leurs grilles à la masse. La tension d'alimentation appliquée sur l'entrée Hv est ainsi reproduite sur le noeud de sortie Vout.

Lorsqu'un niveau logique haut est appliqué sur l'entrée de commande Vcom, les transistors N1 et P2, P3 et P4 sont bloqués. Le transistor N2 est rendu passant et rend le transistor P1 passant. Lorsque le niveau sur le noeud de sortie Vout dépasse le niveau Hv, la tension sur le noeud de sortie NS2 devient Vout-VD1 (Vd1 étant la tension de seuil de la diode D1). La solution proposée se passant de condensateur entre les noeuds de sortie NS1 et NS2, le commutateur 2 n'est alors pas rendu passant par ce niveau de tension sur le noeud NS2. La commutation des transistors P3 et P4 est ainsi insensible aux niveaux de tension sur le noeud Vout. Une surconsommation de courant est ainsi évitée. En outre, le signal de commande à appliquer sur l'entrée Vcom est continu pour un état de conduction donné du commutateur 2. Les circuits générant les commandes du dispositif 1 peuvent ainsi être considérablement simplifiés. La surface de substrat utilisée pour intégrer le commutateur 2, le dispositif 1 et son circuit de commande peut ainsi être réduite.

Les transistors P1, P2, P3 et P4 sont des transistors haute tension à oxyde de grille épais aptes à résister aux niveaux de tension des noeuds Vout et Hv pouvant être appliqués sur leurs grilles et aux niveaux de tension drain-source pouvant leur être appliqués. Le dispositif 1 et le commutateur 2 pouvant être intégrés dans un multiplexeur de hautes tensions, les niveaux des tensions Vout et Hv susceptibles d'être appliqués sont supérieurs à 20 Volts et peuvent atteindre 80 Volts, 90 Volts, 100 Volts ou plus. Ces transistors P1 à P4 présentant une tension Vt de l'ordre de 9V, le commutateur analogique et le dispositif de décalage de niveau de tensions sont particulièrement appropriés pour un niveau de tension Hv supérieur à 20 Volts, et en particulier lorsque ce niveau de tension est supérieur à 50 Volts, voire supérieur à 100 Volts.

La figure 4 illustre un multiplexeur de tension 3 selon l'invention. Le multiplexeur de tension 3 comprend un dispositif de commande 4 fournissant des signaux de commande à différentes sources de tension. Le dispositif de décalage de niveau de tension 1 reçoit ainsi un signal de commande sur son entrée de commande Vcom1. Le multiplexeur de tension 3 comprend en outre des sources de tension 52 à 5n, recevant respectivement des tensions d'alimentation Hv2 à Hvn et des signaux de commande Vcom₂ à Vcomₙ. Le dispositif de commande 4 fournit sélectivement un signal de commande activant soit le dispositif 1, soit une des sources de tension 52 à 5n, de sorte qu'une des tensions d'alimentation Hv1 à Hvn soit appliquée sur le noeud de sortie Vout.

Un tel multiplexeur de tension 3 peut par exemple être intégré dans un dispositif de pilotage d'un afficheur. Un tel afficheur est par exemple un écran à cristaux liquides d'un appareil numérique dont les électrodes de pixel sont sélectivement connectées à la tension de sortie fournie par le multiplexeur 3.

L'afficheur ou écran d'affichage présente par exemple une matrice d'affichage avec des pixels à cristaux liquides cholestériques, avec des pixels à poudre électronique liquide ou tout autre type de pixel faisant appel à au moins trois niveaux de tensions de commande, dont au moins deux sont des niveaux haute tension.

## Revendications

1. Dispositif de décalage de niveau de tension (1), **caractérisé en ce qu'**il comprend :
- une entrée de commande (Vcom) ;
- des premier et seconds noeuds de sortie(NS1, NS2) ;
- des premier et deuxième transistors haute tension à oxyde de grille épais d'un premier type (P1, P2), présentant chacun une première et une deuxième électrode de conduction et une grille, la première électrode de conduction du premier transistor étant connectée au premier noeud de sortie, la seconde électrode de conduction de chacun de ces transistors étant connectée au second noeud de sortie, la grille de chacun de ces transistors étant connectée à la première électrode de conduction de l'autre de ces transistors ;
- des troisième et quatrième transistors CMOS haute tension d'un second type (N1, N2), présentant chacun une première électrode de conduction connectée à la masse, présentant chacun une seconde électrode de conduction dont l'une est connectée à la première électrode de conduction du premier transistor et dont l'autre est connectée à la première électrode de conduction du second transistor, leurs grilles étant connectées ensembles par l'intermédiaire d'un inverseur et l'une de ces grilles étant connectée à l'entrée de commande.

2. Dispositif selon la revendication 1, dans lequel les premier et second transistors (P1, P2) sont de type PMos et leur première électrode de conduction est leur drain, les troisième et quatrième transistors (N1, N2) sont de type NMos et leur première électrode de conduction est leur source.

3. Dispositif selon l'une quelconque des revendications précédentes, dans lequel la tension drain-source maximale de chacun desdits transistors est supérieure à 20 Volts.

4. Dispositif selon l'une quelconque des revendications précédentes, dans lequel la tension maximale grille-source des premier et deuxième transistors est supérieure à 20 Volts.

5. Commutateur analogique (2) à haute tension, **caractérisé en ce qu'**il est destiné à être commandé par un dispositif de décalage de niveau de tension selon l'une quelconque des revendications précédentes, et **en ce qu'**il comprend :
- des premier et second noeuds d'entrée ;
- un noeud de sortie (Vout) et une entrée d'alimentation haute tension (Hv) ;
- des premier et second transistors haute tension à oxyde de grille épais d'un premier type (P3, P4), présentant chacun une première et une deuxième électrode de conduction et une grille, leurs grilles étant connectées au premier noeud d'entrée, leurs deuxièmes électrodes de conduction étant connectées au second noeud d'entrée, leurs premières électrodes de conduction étant connectées respectivement à l'entrée d'alimentation haute tension et au noeud de sortie.

6. Système comprenant :
- un dispositif de décalage de niveau de tension (1) selon l'une quelconque des revendications 1 à 4;
- un commutateur analogique (2) à haute tension selon la revendication 5, dont les premier et second noeuds d'entrée sont connectés respectivement aux premier et second noeuds de sortie du dispositif.

7. Système selon la revendication 6, comprenant une alimentation supérieure à 20 Volts connectée à l'entrée d'alimentation.

8. Multiplexeur de tensions (3), comprenant :
- un système selon la revendication 6 ou 7 ;
- au moins une source de tension (52) :
- présentant une entrée d'alimentation (Hv2) à un niveau de tension supérieur à celui appliqué sur l'entrée d'alimentation haute tension du commutateur analogique du système, une entrée de commande (Vcom2) et un noeud de sortie connecté au noeud de sortie du système ;
- apte à appliquer le niveau de tension de son entrée d'alimentation sur son noeud de sortie lors de l'application d'un signal de commande approprié sur son entrée de commande ;
- une sortie connectée au noeud de sortie du système et au noeud de sortie de la source de tension ;
- un dispositif de commande (4) apte à appliquer sélectivement des signaux de commande sur les entrées de commande respectives du dispositif de décalage de niveau de tension du système et de la source de tension de sorte que le commutateur du système ou la source de tension applique le niveau de tension de son entrée d'alimentation sur son noeud de sortie.

9. Ecran d'affichage, comprenant :
- une matrice de pixels, chaque pixel présentant deux électrodes et étant commandé par une différence de tension entre ses électrodes;
- un pilote d'affichage comprenant un multiplexeur de tensions selon la revendication 8, commandant au dispositif de commande l'application d'un niveau de tension donné sur la sortie du multiplexeur, connectant une électrode d'un pixel à la sortie du multiplexeur.

10. Ecran d'affichage selon la revendication 9, dans lequel la matrice est une matrice de pixels à cristaux liquides cholestériques.
